(19) **Europäisches Patentamt / European Patent Office / Office européen des brevets**

(11) **EP 1 646 700 B1**

(12) # EUROPEAN PATENT SPECIFICATION

(45) Date of publication and mention
of the grant of the patent:
**11.03.2009 Bulletin 2009/11**

(51) Int Cl.:
*C09K 3/14* (2006.01)  *C01F 17/00* (2006.01)
*C09G 1/00* (2006.01)  *H01L 21/304* (2006.01)

(21) Application number: **04747955.5**

(22) Date of filing: **20.07.2004**

(86) International application number:
**PCT/JP2004/010592**

(87) International publication number:
**WO 2005/007769 (27.01.2005 Gazette 2005/04)**

(54) **METHOD FOR PRODUCING CERIUM OXIDE ABRASIVES UPON SETTING THE FIRING TEMPERATURE OF CERIUM CARBONATE**

VERFAHREN ZUR HERSTELLUNG VON CEROXID-SCHLEIFMITTELN DURCH EINSTELLUNG DER BRENNTEMPERATUR VON CERCARBONAT

PROCEDE DE PRODUCTION D'ABRASIFS D'OXYDE DE CERIUM PAR FIXATION DE LA TEMPERATURE DE CHAUFFAGE DE CARBONATE DE CERIUM

(84) Designated Contracting States:
**AT BE BG CH CY CZ DE DK EE ES FI FR GB GR HU IE IT LI LU MC NL PL PT RO SE SI SK TR**

(30) Priority: **17.07.2003 JP 2003198726**

(43) Date of publication of application:
**19.04.2006 Bulletin 2006/16**

(73) Proprietor: **Showa Denko K.K.
Tokyo 105-8518 (JP)**

(72) Inventor: **MIZUKAMI, Hiroshi,
c/o Shiojiri Plant
Shiojiri-shi, Nagano 3996461 (JP)**

(74) Representative: **Strehl Schübel-Hopf & Partner
Maximilianstrasse 54
80538 München (DE)**

(56) References cited:
EP-A- 1 148 538    EP-A- 1 201 607
EP-A- 1 335 011    EP-A- 1 371 707
DE-A- 10 251 029

- PATENT ABSTRACTS OF JAPAN vol. 2000, no. 21, 3 August 2001 (2001-08-03) & JP 2001 089748 A (SEIMI CHEM CO LTD), 3 April 2001 (2001-04-03)
- PATENT ABSTRACTS OF JAPAN vol. 1999, no. 04, 30 April 1999 (1999-04-30) & JP 11 012561 A (SEIMI CHEM CO LTD), 19 January 1999 (1999-01-19)
- IVANOV E N ET AL: "Effect of the heat treatment of cerium carbonate on the microstructure and polishing capacity of cerium dioxide" CHEMICAL ABSTRACTS + INDEXES, AMERICAN CHEMICAL SOCIETY. COLUMBUS, US, vol. 111, no. 16, 16 October 1989 (1989-10-16), page 157, XP002977021 ISSN: 0009-2258
- PATENT ABSTRACTS OF JAPAN vol. 2003, no. 03, 5 May 2003 (2003-05-05) & JP 2002 327171 A (MITSUI MINING & SMELTING CO LTD), 15 November 2002 (2002-11-15)

**Description**

Technical Field

The present invention relates to a method for producing high-purity cerium oxide abrasives for planarization of semiconductors.

Background Art

Conventionally, abrasives employing high-purity silicon oxide have been used in a planarization process of semiconductors. In recent years, high-purity cerium oxide abrasives have been more often employed in a planarization process. Use of cerium oxide is advantageous in that a higher processing rate can be provided as compared with silicon oxide abrasives and that a wide range of additives can be used for preparing a slurry that is stable over a wide pH range.

However, cerium oxide has drawbacks, in that polished surfaces are readily scratched as compared.with conventionally used silicon oxide abrasives and that cerium oxide abrasives provide polishing performance less consistent than silica-based abrasives.

High-purity cerium oxide abrasives are produced by firing a high-purity raw material such as cerium carbonate, cerium monoxycarbonate, or cerium oxalate. Japanese unexamined Patent Publication (*kokai*) No. 11-181404 discloses that cerium carbonate is employed as a raw material. Alternatively, cerium oxide abrasives are produced by synthesizing cerium hydroxide from a soluble cerium compound such as a nitrate or a chloride, firing the hydroxide, and performing pulverization and classification.

A cerium salt of poor solubility such as cerium carbonate, cerium monoxycarbonate, or cerium oxalate is produced from a water-soluble cerium(III) salt such as a nitrate or a chloride. Elements such as alkali metals, alkaline earth metals, rare earth metals (other than cerium), and transition metal elements are removed through chemical operations such as double salt deposition, solvent extraction, and ion exchange. The purity of a poor-solubility cerium salt such as cerium carbonate depends on the purity of a soluble cerium salt employed as a raw material. At present, cerium carbonate having a metallic ion impurity content less than 100 ppm is commercially available on the market.

One important factor affecting the polishing performance of cerium oxide abrasives is a crystal growth feature of cerium oxide. The crystal growth feature is affected by factors such as maximum firing temperature, retention time, and temperature elevation rate. When a high firing temperature is employed, primary particles have a considerably large particle size, resulting in scratching of polished surfaces, whereas when a low firing temperature is employed, the specific surface area of cerium oxide increases, resulting in adhesion or aggregation.

When cerium oxide abrasives are produced from cerium carbonate as a raw material, strict limitations are imposed on the aforementioned firing conditions. Since crystal morphology and purity of cerium carbonate vary in accordance with producers and product lots, optimum firing conditions are not consistently determined. Thus, the firing conditions must be modified on a case-by-case basis, and such modification causes variation in quality of cerium oxide abrasives.

A number of conventional techniques including intentionally incorporating fluorine into cerium oxide abrasives have been reported. For example, Japanese unexamined Patent Publication (*kokai*) No. 2002-327171 discloses a method for producing a cerium-containing abrasive characterized in that a raw material and a solution containing a fluorine component are mixed to form a slurry, whereby the raw material contained in the slurry is pulverized. The document discloses that the fluorine component concentration is preferably 0.01 wt.% to 1.0 wt.% for polishing glass substrates for electronic elements. However, the effect of fluorine described in the publication is to reduce coarse particles during pulverization of raw material, and the publication provides no description of the effect of fluorine on growth of cerium oxide particles during firing.

Japanese unexamined Patent Publication (*kokai*) No. 2003-27044 discloses a cerium-containing abrasive having a fluorine content of 0.1% or more, and a $CeO_2$ content of 30% or more in the entire content of rare earth oxides. In the production of the abrasive, a rare earth element such as Sc, Y, or La forming a stable phase composed of $Ln_2O_3$ is used in an amount equal to or greater than the amount required to form $LnF_3$ or LnOF, and the total amount of the aforementioned rare earth element (as reduced to oxide) is adjusted to 70% or less in the total amount of the rare earth metal oxides. In Japanese unexamined Patent Publication (*kokai*) No. 2003-27044, the relationship between fluorine and trivalent rare earth elements is described from the viewpoint of stoichiometry, and the effect of fluorine is described as preventing hydration of light rare earth metal oxide by trivalent rare earth metal fluoride or oxyfluoride. The effect differs completely from the effect of fluorine contained in high-purity cerium oxide having an extremely small trivalent rare earth element content.

Japanese unexamined Patent Publication (*kokai*) No. 9-183966 also describes fluoridation of light rare earth elements. The gist of Japanese unexamined Patent Publication (*kokai*) No. 2003-27044 is identical to that of Japanese unexamined Patent Publication (*kokai*) No. 9-183966.

Japanese unexamined Patent Publication (*kokai*) No. 2002-97458 describes a method of quality inspection of abrasives which contain a fluorine component and La and Nd in amounts of 0.5 at.% or more based on Ce and have a specific surface area of 12 m$^2$/g or less. The publication describes the relationship between the fluorine content and the firing temperature in the presence of a relatively large amount of La, Nd, and fluorine, but provides no description about characteristic growth of particles of high-purity cerium oxide generally having an La content less than 0.01%.

Japanese unexamined Patent Publication (*kokai*) No. 2001-89748 discloses an abrasive characterized by having a ratio of cerium oxide content/total rare earth element content of 95% or more and having a fluorine content of 1 wt.% or less. The example section of Japanese unexamined Patent Publication (*kokai*) No. 2001-89748 describes firing at 750°C, but describes no relationship between optimum firing temperature and fluorine content (microamount of 0.05% (500 ppm) or less).

The allowable metal impurity level of cerium oxide abrasives employed for polishing semiconductors is subjected to strict limitations, as compared with conventionally employed cerium-containing abrasives. In order to satisfy the impurity level, high-purity (catalyst grade) cerium carbonate is often employed as a raw material. This means that cerium carbonate from which fluorine has been removed or cerium carbonate having an uncontrolled fluorine content is employed as a raw material.

In Japanese unexamined Patent Publication (*kokai*) No. 11-181404, a wide range of particle size of cerium carbonate is claimed, along with a wide range of firing temperature (600°C to 900°C). However, in order to produce cerium oxide for semiconductor abrasives through firing, firing temperature must be controlled in a narrower range. Japanese unexamined Patent Publication (*kokai*) No. 11-181404 provides no description about the effect of fluorine as an impurity element under such strict quality control conditions, since it was not considered that the presence of fluorine affects high-purity cerium carbonate for conventional use.

Conventionally, low-quality cerium oxide abrasives, which may contain fluorine, are produced from cerium carbonate containing a large amount of fluorine serving as a raw material. However, preferably as low fluorine as possible is contained in cerium carbonate serving as a raw material to produce high-quality cerium oxide abrasives. Nevertheless, even when a raw material may contain a trace amount of fluorine, such a raw material is considered pure cerium carbonate while the presence of fluorine is ignored, and is fired at a firing temperature of pure cerium carbonate. As a result, variations arise in quality of the produced cerium oxide abrasives.

Patent Abstracts of Japan, vol. 2000, no. 21, 3 August 2001 (2001-08-03)& JP 2001 089748 A (Seimi Chem Co., Ltd.), 3 April 2001 (2001-04-03) discloses a method of producing a cerium oxide abrasive with a fluorine impurity level of less than 1000 ppm comprising firing a carbonic acid ore fluoride mineral at a firing temperature of preferably 750 to 850 °C.

Patent Abstracts of Japan, vol. 1999, no. 04, 30 April 1999 (1999-04-30)& JP 11 012561 A (Seimi Chem Co., Ltd.), 19 January 1999 (1999-01-19) discloses a method of producing a cerium oxide abrasive comprising calcining a carbonate salt having an impurity content of less than 10 ppm at a temperature of 600 to 800 °C.

An object of the present invention is to provide a method for producing a cerium oxide abrasive from cerium carbonate as a raw material, without variation in quality, on the basis of studies on variation in quality generated during firing of cerium carbonate.

Disclosure of The Invention

The present inventor has revealed that fluorine contained in cerium carbonate affects crystal growth of cerium oxide, and has found that variation in crystal growth feature during firing can be prevented by controlling firing conditions in accordance with the fluorine content. According to the method of the present invention, abrasives without variation in quality can be produced from fluorine-containing cerium carbonate serving as a raw material.

Accordingly, the present invention provides the following.

(1) A method for producing a cerium oxide abrasive comprising firing a raw material of cerium carbonate having a fluorine content falling within a range of 10 to 500 ppm by mass, at a firing temperature T (°C) which is chosen as follows:

a) firing cerium carbonate with a fluorine content F1 which is 10 ppm or less by mass and determining a temperature T1 which yields cerium oxide with specific surface area in the range 9.5-12.2 m$^2$/g;

b) firing cerium carbonate with a fluorine content F2 which is in the range 50-300 ppm by mass and determining a temperature T2 which yields cerium oxide with specific surface area in the range 9.5-12.2 m$^2$/g:

c) using the data from (a) and (b) to calculate A and B which are constants inherent to the firing furnace and the temperature elevation condition used in said firing, said constants being obtained from the following formulae:

$$T1=(700+A)-B[\log(F1)]$$

$$T2=(700+A)-B[\log(F2)]$$

d) using the A and B values from (c) in the equation $T=(700+A)-B[\log(F)]$ to determine the firing temperature T of the cerium carbonate.

(2) The method for producing a cerium oxide abrasive as recited in (1) above, further comprising removing soluble fluorine from the cerium oxide abrasive.

(3) A method for producing a cerium oxide abrasive slurry, comprising the method for producing a cerium oxide abrasive as recited in (1) or (2) above.

Brief Description of the Drawings

Fig. 1 shows the relationship between specific surface area and optimum firing temperature with respect to different fluorine contents of starting cerium carbonate.
Fig. 2 shows the relationship between fluorine content of starting cerium carbonate and firing temperature range.

Best Modes for Carrying Out the Invention

The present invention is directed to a method for producing a cerium oxide abrasive including firing cerium carbonate. The present inventor focused on the impurity present in a small amount in cerium carbonate, and has found that a small amount of fluorine contained in cerium carbonate affects a crystallization feature of cerium oxide formed through firing, and that variation in crystallization feature can be prevented by controlling firing temperature in accordance with the fluorine content.
When high-purity cerium carbonate having a fluorine content particularly less than 5 ppm by mass is fired, the produced cerium oxide has satisfactory crystal quality and specific surface area, whereas when the fluorine content is particularly 10 ppm by mass or more, the fired cerium oxide undergoes excessive crystal growth and has a decreased specific surface area. The tendency of overgrowth and decrease in surface area becomes more remarkable as the fluorine content increases. A crystallization feature and the specific surface area of cerium oxide can be kept within a narrow range by selecting, as the fluorine content increases, the firing temperature lower than the firing temperature in the case of the pure cerium carbonate. Notably, high-purity cerium carbonate rarely has a fluorine content in excess of 500 ppm, and locally occurring anomalous particle growth of high-purity cerium carbonate containing small amounts of other rare earth elements (e.g., La) tends to occur by simply lowering the firing temperature. Thus, the upper limit of the fluorine content of the raw material of cerium carbonate is 500 ppm by mass, more preferably 300 ppm by mass.
Thus, by controlling the firing temperature of cerium carbonate serving as a raw material in accordance with the fluorine content of the raw material, the produced cerium oxide lots have excellent quality (i.e., crystal quality and specific surface area), with less variation thereof within the lots, comparable to that of cerium oxide produced from pure cerium carbonate as a raw material.

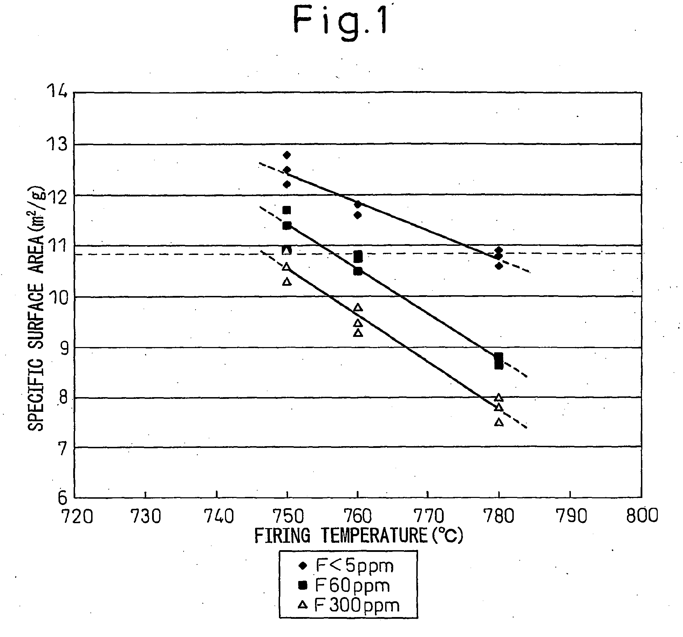

Fig. 1 shows the relationship between specific surface area and optimum firing temperature with respect to different fluorine contents of starting cerium carbonate. In Fig. 1, the specific surface area decreases as the firing temperature is elevated, regardless of fluorine content (less than 5 ppm by mass, 60 ppm by mass, and 300 ppm by mass) in cerium carbonate serving as a raw material. When the fluorine content of cerium carbonate serving as a raw material increases, the specific surface area decreases. Thus, it is understood that, when cerium carbonate serving as a raw material has a large fluorine content, by lowing the firing temperature in accordance with the fluorine content, cerium oxide having an optimum specific surface area can be obtained. The preferred specific surface area of cerium oxide varies depending on use thereof and the particle size of abrasives. In the abrasive used, for example, for polishing semiconductors, cerium oxide preferably has a specific surface area of 9.5 to 12.2 $m^2$/g, most preferably 10.5 to 11.5 $m^2$/g. Although not illustrated, when cerium carbonate having a high fluorine content is fired at too high firing temperature, excessive growth occurs, scratches may be formed on the polished surface. When the specific surface area falls within the aforementioned preferred or optimum range, the crystal-related properties are preferable or most preferable.

The optimum firing temperature can be determined, for example, by first collecting data on the optimum firing temperatures depending on the fluorine contents of cerium carbonate and using the obtained data base. More specifically, preliminary tests on cerium carbonates with various fluorine contents are conducted to obtain optimum firing temperatures, for a specific firing furnace and firing conditions, and, thereafter, the same firing temperatures revealed can be used for cerium carbonates having the corresponding fluorine contents.

More easily, the optimum firing temperature can be obtained by the following method.

Cerium carbonate serving as a raw material having a fluorine content of 10 to 500 ppm by mass, preferably 50 to 300 ppm by mass, is fired at a temperature satisfying the equation:

$$T = (700 + A) - B[\log(F)]$$

wherein T represents firing temperature (°C) of cerium carbonate, F represents fluorine content (ppm by mass) of cerium carbonate, and A and B represent constants that are determined by the firing furnace and temperature elevation conditions employed,

to thereby form high-quality cerium oxide suitable for abrasives, even through pure cerium carbonate serving as a raw material having a fluorine content less than 5 ppm by mass is not employed.

The values "A" and "B" are determined from the results of firing experiments of two cerium carbonates having different fluorine contents. For example, where T1 and F1, and T2 and F2, are optimum firing temperatures (°C) and fluorine contents (ppm by mass), respectively, of two cerium carbonates different in fluorine content and known in their optimum firing temperatures (the optimum firing temperature can be obtained from a preliminary test, for example), "A" and "B" can be determined from the following simultaneous equations:

$$T1 = (700 + A) - B[\log(F1)]$$

$$T2 = (700 + A) - B[\log(F2)]$$

The fluorine contents of the above two cerium carbonates are preferably 10 ppm by mass or less for the one and 50-300 ppm by mass for the other one, since they can provide more precise "A" and "B" values.

When pure cerium carbonate serving as a raw material having a fluorine content less than 5 ppm is employed, the term B[log(F)] is virtually negligible. Thus, the value "A" is obtained from the equation: T (optimum firing temperature determined) = (700 + A).

The value "B" is obtained from the equation: T (optimum firing temperature) = (700 + A) - B[log(F)], by inputting a predetermined "A" value and a certain fluorine content (F) [10 to 500 ppm by mass, preferably 50 to 300 ppm by mass] of cerium carbonate serving as a raw material.

Generally, the value "A" is 30 to 90, and the value "B" is 10 to 14.

Accordingly, the firing temperature T generally falls within a range defined by the following formula:

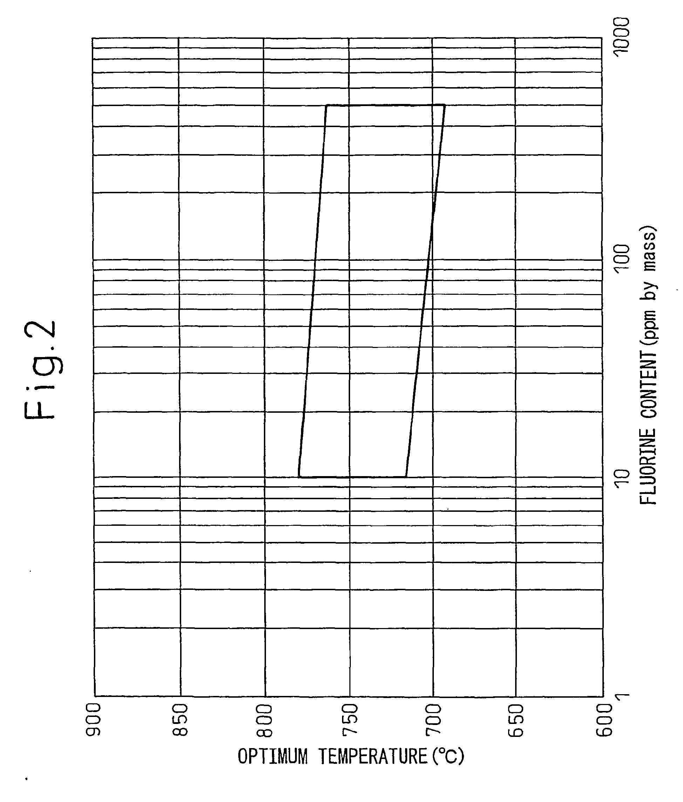

$$730 - 14[\log(F)] \le T \le 790 - 10[\log(F)]. \quad \text{Fig. 2}$$

shows this range.

The fluorine content of high-purity cerium carbonate varies depending on the method for producing high-purity cerium carbonate. Ores such as bastnaesite, monazite, and ion-adsorbed ores are known as raw materials of rare earth ores. Among them, bastnaesite ore is a type of fluoride and serves as a fluorine source. (However, if an appropriate chemical treatment is performed, fluorine can be removed even when bastnaesite is employed.) By determining the fluorine content of cerium carbonate produced through purification of any ore, and by employing firing conditions suitable for the fluorine content, cerium oxide with variation-free crystal properties can be obtained.

The fluorine in high purity cerium carbonate serving as the raw material tends to be entrained in the obtained cerium oxide. However, among the fluorine entrained in the cerium oxide, the fluorine which may affect the polishing or the like is soluble fluorine. The cerium oxide obtained in accordance with the present invention usually contains a less amount of soluble fluorine and, therefore, can be used for applications such as semiconductor polishing without problems. The soluble fluorine content of the cerium oxide is typically about 20 to 1000 ppm by mass.

If the soluble fluorine content of the cerium oxide should be reduced further, removal of soluble fluorine from the obtained cerium oxide, for example, washing with water, may be effected. By this treatment, the cerium oxide obtained in accordance with the present invention may be used similarly to cerium oxide obtained from pure cerium carbonate.

The soluble fluorine content of cerium oxide may be determined by suspending cerium oxide in an aqueous alkaline solution and subjecting the supernatant to anion chromatography. Alternatively, colorimetric analysis may be employed

Crystallinity of cerium oxide is evaluated through a known means such as observation under a transmission electron microscope or a scanning electron microscope.

Determination of an X-ray diffraction peak width is employed for roughly, and indirectly, evaluating the entirety of a sample. When cerium oxide is a sample, the most intense peak (111) is generally employed. However, diffraction at a higher angle is preferably employed for enhancing precision, from the viewpoint of quality control of abrasives. Strictly speaking, in order to determine a full width at half maximum (FWHM; also referred to as "a half-width"), a monochrometer is not used so as to avoid influence of adjustment of the monochrometer, and the intensity ratio of $CuK\alpha1$ to $K\alpha2$ must be adjusted to 2 : 1 by use of an Ni filter, with performing peak separation based on a Cauchy-type curve or a Gaussian curve. However, routine measurement can be carried out through comparison with a standard sample.

Specific surface area is more readily determined, and the values are employed in production step control. Notably, X-ray diffraction analysis values and specific surface area are parameters which reflect crystallinity as well as other properties. Thus, these parameters must be determined under normalized conditions.

The gist of the present invention resides in controlling firing temperature so as to compensate a particle growth promoting effect exerted by fluorine, and the invention has been derived from the inventor's finding that fluorine is readily incorporated into high-purity cerium carbonate, which finding was obtained through his research focusing on the role of anionic impurities, which have not been considered to be a factor of quality variation in cerium oxide abrasives produced from high-purity cerium carbonate. According to the present invention, high-purity cerium oxide abrasives can be provided from cerium carbonate containing fluorine as an impurity, without variation in quality.

The range of modifying the firing temperature in accordance with the fluorine content is generally about 10°C to about 50°C. Thus, in the production of cerium oxide lots, for each of which a firing test should have been conducted in many cases, a means for determining the firing temperature in accordance with the fluorine content is advantageous from the viewpoint of enhancement of production efficiency and reduction of variation in quality.

Examples

The present invention will next be described in detail by way of examples, which should not be construed as limiting the invention thereto.

Referential Example (Cerium oxide slurry production 1)

Cerium carbonate (fluorine content: <5 ppm) (1 kg) was placed in an alumina crucible and fired at 780°C for three hours, to thereby produce a cerium oxide powder. The powder (1.2 kg) was further pulverized by use of a ball mill in a dry format, and the pulverization was terminated when the cumulative amount of the pulverized product which had passed through a 1-$\mu$m sieve reached 50%, as determined by means of a laser diffraction particle size distribution analyzer (CILAS 850, product of CILAS ALCATEL). A portion of the thus-pulverized cerium oxide powder was employed as a sample for soluble fluorine analysis. The produced cerium oxide powder (600 g) was added to water (1,400 g), and a dispersant (commercial product) (3 g) was added to the mixture, followed by mixing by means of a high-speed mixer, to thereby form a slurry. The slurry was placed in a 2-L beaker and allowed to stand for 24 hours. An upper liquid portion (from the liquid surface of the slurry to the depth of 10 cm) was collected from the slurry through settling classification. The collected cerium oxide slurry was dried at 150°C, and the dried product was employed as a sample for specific surface area determination and a sample for X-ray diffraction analysis. Specific surface area was determined by use of Multisorb (product of Yuasa Kikai), and X-ray diffractometry was performed by use of an X-ray diffractometer (product of Rigaku Denki Kogyo) employing a high-angle diffraction ray corresponding to Miller indices of (440) so as to enhance measurement precision of half-width values. Soluble fluorine content was determined through ion chromatography, wherein the samples were prepared by adding pulverized product (1 g) of cerium oxide to a 0.01 mol/L aqueous sodium hydroxide solution, subjecting the mixture to ultrasonic dispersion for 20 minutes, and collecting the supernatant through filtration. Soluble fluorine content of the slurry was determined through ion chromatography, wherein the samples were prepared by diluting the aforementioned slurry collected through settling classification with pure water so as to adjust the slurry concentration to 10%, centrifuging the slurry, collecting the supernatant, and subjecting the supernatant to filtration.

Example 1 (Cerium oxide slurry production 2)

In a manner similar to Referential Example, cerium carbonate (1 kg) having a fluorine content of 300 ppm was fired at 750°C for three hours, and analytical samples were prepared.

Example 2 (Cerium oxide slurry production 3)

In a manner similar to Referential Example, cerium carbonate (1 kg) having a fluorine content of 60 ppm was fired at 760°C for three hours, and analytical samples were prepared.

Comparative Example 1 (Cerium oxide slurry production 4)

In a manner similar to Referential Example, cerium carbonate (1 kg) having a fluorine content of 300 ppm was fired at 780°C, and analytical samples were prepared.

Comparative Example 2 (Cerium oxide slurry production 5)

In a manner similar to Referential Example, cerium carbonate (1 kg) having a fluorine content of 60 ppm was fired at 780°C, and analytical samples were prepared.

Table 1

| | Fluorine concentration in cerium carbonate (ppm) | Firing temperature (°C) | Specific surface area ($m^2$/g) | Half-width (°) |
|---|---|---|---|---|
| Ref. Ex. | <5 | 780 | 10.8 | 0.45 |
| Ex. 1 | 300 | 750 | 10.6 | 0.44 |
| Ex. 2 | 60 | 760 | 10.7 | 0.44 |
| Comp. Ex. 1 | 300 | 780 | 7.8 | 0.33 |
| Comp. Ex. 2 | 60 | 780 | 8.7 | 0.37 |

Cerium oxide samples produced by firing cerium carbonate containing fluorine at 780°C (Comp. Exs. 1 and 2) were found to have a small specific surface area and a small half-width, as compared with a cerium oxide sample produced by firing cerium carbonate (fluorine content <5 ppm) at the same temperature. The results indicate that the samples of Comparative Examples 1 and 2 have a larger crystallite size. Cerium oxide samples produced by firing cerium carbonate containing fluorine at a temperature controlled according to the method of the present invention (Exms. 1 and 2) were found to have a specific surface area and a half-width comparable to those of the sample of Referential Example.

Table 2

| | Fluoride ion concentration of NaOH solution (leachant) ($\mu$g/g-cerium oxide) | Fluoride ion concentration of 10% slurry ($\mu$m/mL-slurry) |
|---|---|---|
| Ref. Ex. | <5 | 4 |
| Ex. 1 | 230 | 40 |
| Ex. 2 | 40 | 10 |
| Comp. Ex. 1 | 220 | 38 |
| Comp. Ex. 2 | 40 | 10 |

In all the samples (in Examples 1 and 2 and Comparative Examples 1 and 2), soluble fluorine was detected. The fluorine contained in the slurry includes fluorine ions derived from raw materials other than the cerium carbonate.

Example 3 (Washing cerium oxide slurry with water)

A 5% slurry was prepared from cerium carbonate employed in Example 1. The slurry (30 kg) was washed with water by use of a microfilter. The soluble fluoride ion concentration of each filtrate was determined before and after washing with water. In this analysis, the slurry was centrifuged and the supernatant was filtered by means of a membrane filter. Fluoride ion concentration of each filtrate was determined through ion chromatography. Soluble fluorine concentration was found to have been lowered through washing.

Table 3

|  | Fluoride ion concentration |
|---|---|
| Slurry before washing with water | 40 ppm |
| Slurry after washing with water | 2 ppm |
| *Fluoride ion concentration based on 10% slurry | |

Example 4 (Polishing test)

Concentration of each of the slurry samples prepared in Referential Example, Examples 1 and 2, Comparative Example 1 and 2, and Example 3 was adjusted 1%. A polishing test was carried out by use of each slurry sample.

[Polishing conditions]

Workpiece to be polished:
A silicon dioxide film (thickness: approximately 1 $\mu$m) formed on a silicon wafer (6 inch $\phi$, thickness: 625 $\mu$m) through CVD.
Pad:
Two-layer polishing Pad for semiconductor devices (IC 1000/SUBA 400, product of Rodel Nitta).
Polishing machine:
One-side polishing machine for semiconductor devices (Model SH-24, table plate size: 610 mm; manufactured by Speedfam, Inc.)
Table rotation: 70 rpm
Working pressure: 300 gf/cm$^2$
Slurry feeder: 100 mL/min
Polishing time: 1 min

[Evaluation items and methods]

Polishing rate: Film thickness measuring apparatus (optical interference method)
Defects: Dark-field microscopic observation (magnification of x200, observation of about 3% of the surface area of the wafer, reducing the number of detected defects to count/cm$^2$).
Remaining abrasive grains: Dark-field microscopic observation (magnification of x200, observation of about 3% of the surface area of the wafer, reducing the number of detected defects to count/cm$^2$).

Each workpiece (wafer) was subjected to the aforementioned polishing test, scrub-washing with pure water, and spin-drying, and the thus-treated wafer was evaluated.

Table 4

|  | Polishing rate (Å/min) | Scratches by polishing (count/cm$^2$) | Remaining grains (count/cm$^2$) |
|---|---|---|---|
| Ref. Ex. | 4,340 | 0 | 3.20 |
| Ex. 1 | 4,300 | 0 | 3.05 |
| Ex. 2 | 4,370 | 0 | 3.18 |
| Comp. Ex. 1 | 5,100 | 8 | 2.58 |

(continued)

| | Polishing rate (Å/min) | Scratches by polishing (count/cm$^2$) | Remaining grains (count/cm$^2$) |
|---|---|---|---|
| Comp. Ex. 2 | 4,790 | 5 | 2.88 |
| Ex. 4 | 4,410 | 0 | 3.30 |

Although the slurry samples of Comparative Examples 1 and 2 provided high polishing rate, a number of scratches were formed during polishing, thereby deteriorating the quality of the polished surface. The presence of soluble fluorine had no adverse effect on the quality of the polished surface. However, deterioration of the quality of polished surfaces due to excessive crystal growth was predominant.

Industrial Applicability

The abrasives produced by the method for producing abrasives of the present invention provide a consistent process rate and consistent quality of polished surfaces. Thus, the abrasives are preferably employed in a polishing composition for semiconductors.

**Claims**

1.  A method for producing a cerium oxide abrasive comprising firing a raw material of cerium carbonate having a fluorine content falling within a range of 10 to 500 ppm by mass, at a firing temperature T (°C) which is chosen as follows:

    a) firing cerium carbonate with a fluorine content F1 which is 10 ppm or less by mass and determining a temperature T1 which yields cerium oxide with specific surface area in the range 9.5-12.2 m$^2$/g;
    b) firing cerium carbonate with a fluorine content F2 which is in the range 50-300 ppm by mass and determining a temperature T2 which yields cerium oxide with specific surface area in the range 9.5-12.2 m$^2$/g:
    c) using the data from (a) and (b) to calculate A and B which are constants inherent to the firing furnace and the temperature elevation condition used in said firing, said constants being obtained from the following formulae:

$$\mathtt{T1=(700+A)-B[log(F1)]}$$

$$\mathtt{T2=(700+A)-B[log(F2)]} \quad .$$

    d) using the A and B values from (c) in the equation T=(700+A)-B[log(F)] to determine the firing temperature T of the cerium carbonate.

2.  The method for producing a cerium oxide abrasive according to claim 1, further comprising removing soluble fluorine from the cerium oxide abrasive.

3.  A method for producing a cerium oxide abrasive slurry, comprising the method for producing a cerium oxide abrasive as set forth in claim 1 or 2.

**Patentansprüche**

1.  Verfahren zum Herstellen eines Ceroxid-Schleifmittels, welches das Brennen eines Ausgangsmaterials aus Cercarbonat mit einem Fluorgehalt innerhalb eines Bereichs von 10 bis 500 Massen-ppm bei einer Brenntemperatur T (°C) umfasst, welche wie folgt ausgewählt ist:

    a) Brennen von Cercarbonat mit einem Fluorgehalt F1 von 10 Massen-ppm oder weniger und Bestimmen einer Temperatur T1, bei der Ceroxid mit einer spezifischen Oberfläche im Bereich von 9,5-12,2 m$^2$/g erhalten wird;

b) Brennen von Cercarbonat mit einem Fluorgehalt F2 im Bereich von 50 bis 300 Massen-ppm und Bestimmen einer Temperatur T2, bei der Ceroxid mit einer spezifischen Oberfläche im Bereich von 9,5-12,2 m$^2$/g erhalten wird;

c) Verwenden der Daten aus (a) und (b) zur Berechnung von A und B, welche inhärente Konstanten des Brennofens und der bei dem Brennen eingesetzten Temperaturerhöhungsbedingung sind, wobei die Konstanten durch die folgenden Formeln erhalten werden:

$$T1=(700+A)-B[log(F1)]$$

$$T2=(700+A)-B[log(F2)]$$

d) Verwenden der Werte A und B aus (c) in der Gleichung T=(700+A)-B[log(F)] zur Bestimmung der Brenntemperatur des Cercarbonats.

2. Verfahren zum Herstellen eines Ceroxid-Schleifmittels nach Anspruch 1, das außerdem das Entfernen von löslichem Fluor aus dem Ceroxid-Schleifmittel umfasst.

3. Verfahren zum Herstellen einer Ceroxid-Schleifmittelaufschlämmung, welches das Verfahren zum Herstellen eines Ceroxid-Schleifmittels nach Anspruch 1 oder 2 umfasst.

**Revendications**

1. Procédé de production d'un abrasif d'oxyde de cérium comprenant la cuisson d'une matière première de carbonate de cérium ayant une teneur en fluor comprise dans la plage de 10 à 500 ppm en masse, à une température de cuisson T (en °C) qui est choisie de la manière suivante :

a) cuisson du carbonate de cérium avec une teneur en fluor F1 qui est de 10 ppm ou moins en masse, et détermination de la température T1 qui donne de l'oxyde de cérium avec une surface active spécifique dans la plage de 9,5 à 12,2 m$^2$/g ;

b) cuisson du carbonate de cérium avec une teneur en fluor F2 qui est dans la plage de 50 à 300 ppm en masse, et détermination d'une température T2 qui donne de l'oxyde de cérium avec une surface active spécifique dans la plage comprise entre 9,5 et 12,2 m$^2$/g ;

c) utilisation des données provenant de (a) et (b) pour calculer A et B qui sont des constantes inhérentes au four de cuisson et aux conditions d'élévation de la température utilisées pendant ladite cuisson, lesdites constantes étant obtenues grâce aux formules suivantes :

$$T1 = (700 + A) - B[log(F1)]$$

$$T2 = (700 + A) - B[log(F2)]$$

d) en utilisant les valeurs A et B obtenues dans (c) dans l'équation T = (700 + A) - B[log(F)] pour déterminer la température de cuisson T du carbonate de cérium.

2. Procédé de production d'un abrasif d'oxyde de cérium selon la revendication 1, comprenant en outre l'élimination du fluor soluble dans l'abrasif d'oxyde cérium.

3. Procédé de production d'une boue abrasive d'oxyde de cérium comprenant le procédé de production d'un abrasif d'oxyde de cérium tel que spécifié dans la revendication 1 ou 2.

# Fig.1

# Fig.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11181404 A
- JP 2002327171 A
- JP 2003027044 A
- JP 9183966 A

- JP 2002097458 A
- JP 2001089748 A
- JP 11012561 A

**Non-patent literature cited in the description**

- *Patent Abstracts of Japan,* 03 August 2001, vol. 2000 (21

- *Patent Abstracts of Japan,* 30 April 1999, vol. 1999 (04